**Europäisches Patentamt**

(19) **European Patent Office**

**Office européen des brevets**

(11) Veröffentlichungsnummer: **0 182 742**

**B1**

(12) # EUROPÄISCHE PATENTSCHRIFT

(45) Veröffentlichungstag der Patentschrift:
02.06.89

(21) Anmeldenummer: **85810518.2**

(22) Anmeldetag: **06.11.85**

(51) Int. Cl.⁴: **H 03 G 3/34**, H 03 J 7/18

(54) Schaltungsanordnung zur Erzeugung eines Empfangskriteriums.

(30) Priorität: **15.11.84 CH 5459/84**

(43) Veröffentlichungstag der Anmeldung:
**28.05.86 Patentblatt 86/22**

(45) Bekanntmachung des Hinweises auf die Patenterteilung:
**02.06.89 Patentblatt 89/31**

(84) Benannte Vertragsstaaten:
**AT BE CH DE FR GB IT LI NL SE**

(56) Entgegenhaltungen:
**EP-A-0 027 365**
**WO-A-82/00552**

(73) Patentinhaber: **Ascom Autophon AG,
Ziegelmattstrasse 1-15, CH- 4500 Solothurn 3 (CH)**

(72) Erfinder: **Dreier, Ernst, Riesere 16, CH- 3303
Jegensdorf (CH)**

(74) Vertreter: **Schweizer, Hans, Bovard AG
Patentanwälte VSP Optingenstrasse 16, CH- 3000
Bern 25 (CH)**

EP 0 182 742 B1

## Beschreibung

Bei Empfängern drahtloser Signale besteht oft das Bedürfnis, den Empfang bzw. den Nichtempfang eines Signals in binärer Weise festzustellen. Es ist allgemein üblich, die An- oder Abwesenheit des Signals aus der Stärke des Rauschens am Empfängerausgang abzuleiten. Dabei wird ein Teil des Ausgangssignals über ein Hochpassfilter oder Bandpassfilter geführt, und die im Rauschen enthaltenen, oberhalb des Sprechbereichs liegenden Frequenzen werden zu einem Rauschkriterium verarbeitet, welches die Form eines Gleichspannungspotentials aufweist, dessen Höhe ungefähr proportional zur Stärke des Rauschens ist. Durch eine Vergleichseinrichtung, welche das Rauschkriterium mit einem willkürlich festgelegten Grenzwert-Potential vergleicht, wird dabei ein Empfangskriterium erzeugt, sofern das Rauschkriterium unterhalb des Grenzwert-Potentials liegt. Meist wird das Rauschkriterium ausschliesslich dazu benutzt, bei Abwesenheit eines Signals den Ausgang des Empfängers zu sperren, um eine Störung durch das Rauschen zu vermeiden.

Da die Stärke des Rauschens schwankt, muss, um ein Flattern der Empfangsanzeige bei einem in der Grössenordnung des Grenzwert-Potentials liegenden Rauschkriterium zu verhindern, das Rauschpotential über eine gewisse Zeit integriert werden, bevor es mit dem Grenzwert-Potential verglichen wird. Diese Integration wird bekannterweise mit einer Kapazität erreicht, welcher das Rauschpotential über einen Widerstand zugeführt wird.

Das Einfügen einer solchen Kapazität hat nun jedoch zur Folge, dass der Beginn und die Beendigung des Empfangs eines Signals verzögert festgestellt werden, wobei diese Verzögerung von der Stärke des eintreffenden bzw. des verschwindenden Signals abhängig ist. Bei einem neu eintreffenden Signal ist die Verzögerung um so länger, je schwächer das Signal ist und je kleiner somit der Rückgang des Potentials des Rauschkriteriums ist. Bei einem nur wenig unterhalb des Grenzwert-Potentials liegenden Rauschkriterium ist die Verzögerung sehr gross. Im Gegensatz dazu ist beim Verschwinden eines grossen Signals, wenn somit der Rückgang des Rauschkriteriums gross ist, die Verzögerung ebenfalls gross, während sie beim Verschwinden eines kleinen Signals, bei welchem das entsprechende Rauschkriterium nur wenig unterhalb des Grenzwert-Potentials liegt, nur kurz ist.

Soll in einem bestimmten Zeitpunkt der Nichtempfang eines Signals festgestellt werden, muss, um ein zuverlässiges Ergebnis zu erhalten, eine Zeit abgewartet werden, welche die im ungünstigsten Fall auftretende Zeit zur Feststellung des Empfangs eines Signals übertrifft und deshalb ebenfalls lang ist. Sofern das Rauschkriterium nur dazu benützt wird, die als "Rauschsperre" (Squelch) bekannte Sperrung des Empfängerausgangs zu steuern, stört in erster Linie die lange Verzögerungszeit nach dem Aufhören des Empfangs eines rauschfreien Signals, da das während dieser Verzögerungszeit am Empfängerausgang auftretende Rauschen lästig ist. Beim kurzzeitigen Unterbruch des Empfangs eines schwachen und daher rauschbehafteten Signals stört im Gegensatz dazu das schnelle Ansprechen der Rauschsperre, weil wegen der in diesem Falle verzögerten Aufhebung der Sperre die Verständlichkeit leidet. Eine Schaltungsanordnung, bei welcher die Abhängigkeit der Verzögerungszeit von der Stärke eines verschwindenden Signals gegenüber dem beschriebenen, sich von selber ergebenden Zusammenhang umgekehrt ist und bei welcher somit dem Verschwinden eines starken Signals eine kurze und eines schwachen Signals eine lange Ansprechzeit entspricht, ist beispielsweise in der PCT-Offenlegungsschrift WO 82/00552 beschrieben.

In einem Empfänger, mit welchem ein Bündel von Kanälen nach einem belegten Kanal abgesucht werden soll, werden Messperioden gebildet, von denen jede jeweils mit der Umschaltung auf einen neuen Kanal beginnt. Nach dem Stande der Technik ist es üblich, um eindeutige Verhältnisse zu schaffen am Beginn jeder Messperiode den Eingang der Vergleichseinrichtung kurzzeitig auf ein dem Empfang eines starken Signals entsprechendes (kleines) Potential zu verbringen, worauf dieses Potential anschliessend, entsprechend der genannten Integrationszeitkonstanten, dem dem auftretenden Rauschen entsprechenden Wert zustrebt. Sobald dieses steigende Potential das Grenzwert-Potential überschreitet, wird, veranlasst durch die Vergleichseinrichtung, ein Impuls zur Umschaltung des Empfängers auf einen andern Kanal und damit zur Einleitung einer neuen Messperiode gegeben.

Sofern dabei ein schwaches Signal empfangen wird, welches nicht anerkannt werden soll und bei dem das dem Rauschen entsprechende Potential nur wenig über dem Grenzwert-Potential liegt, dauert die Zeit vom Beginn der Messperiode bis zur Abgabe des genannten Impulses lange, was nachteilig ist, wenn eine grössere Zahl von Kanälen abgesucht werden soll.

In einer Einrichtung zur Suche nach freien Kanälen stellen sich nach dem Stande der Technik ebenfalls den beschriebenen Zeitproblemen entsprechende Probleme, wenn Signale empfangen werden, bei denen das aus der Rauschspannung abgeleitete Potential nur wenig unterhalb des Grenzwert-Potentials liegt.

Eine nach diesen Grundsätzen arbeitende und daher mit den erwähnten Nachteilen in der Geschwindigkeit der Arbeitsweise behaftete, ausschliesslich zum Absuchen von Kanälen bestimmte Einrichtung ist in der europäischen Offenlegungsschrift 27 365 beschrieben.

Mit der vorliegenden Erfindung wird nun die Aufgabe gelöst, beim abwechslungsweisen Empfang auf verschiedenen Kanälen die Zeit zur Feststellung des Empfangs eines Signals oder zur

Feststellung des Nichtempfangs eines Signals im Vergleich zu herkömmlichen und naheliegenden Schaltungsanordnungen wesentlich zu verkürzen, obwohl in beiden Fällen auch der Empfang schwacher Signale berücksichtigt wird. Die Erfindung betrifft eine Schaltungsanordnung nach dem Oberbegriff des Anspruchs 1, deren Kennzeichen im kennzeichnenden Teil dieses Anspruchs festgehalten sind.

Mit einer im Patentanspruch 2 beschriebenen besondern Ausführungsform der Erfindung wird die weitere Aufgabe gelöst, die im Anspruch 1 alternativ angegebenen Möglichkeiten zu kombinieren.

In der Folge wird die Erfindung anhand eines Ausführungsbeispiels erklärt.

Die Figur 1 zeigt das vereinfachte Schema einer Schaltungsanordnung gemäss dem Patentanspruch 2.

Die Figur 2 zeigt in vier, auf vier verschiedene Pegel des Rauschkriteriums bezogenen Teilfiguren a - d den zeitlichen Verlauf von mehreren Potentialen in einer Schaltungsanordnung gemäss Figur 1. Dabei ist (fiktiv) vorausgesetzt, dass sich das Rauschkriterium in aufeinanderfolgenden Messperioden ändert.

Die Figur 3 zeigt die zeitlichen Verhältnisse beim Empfang eines schwachen Signals in einer Einrichtung nach dem Stande der Technik.

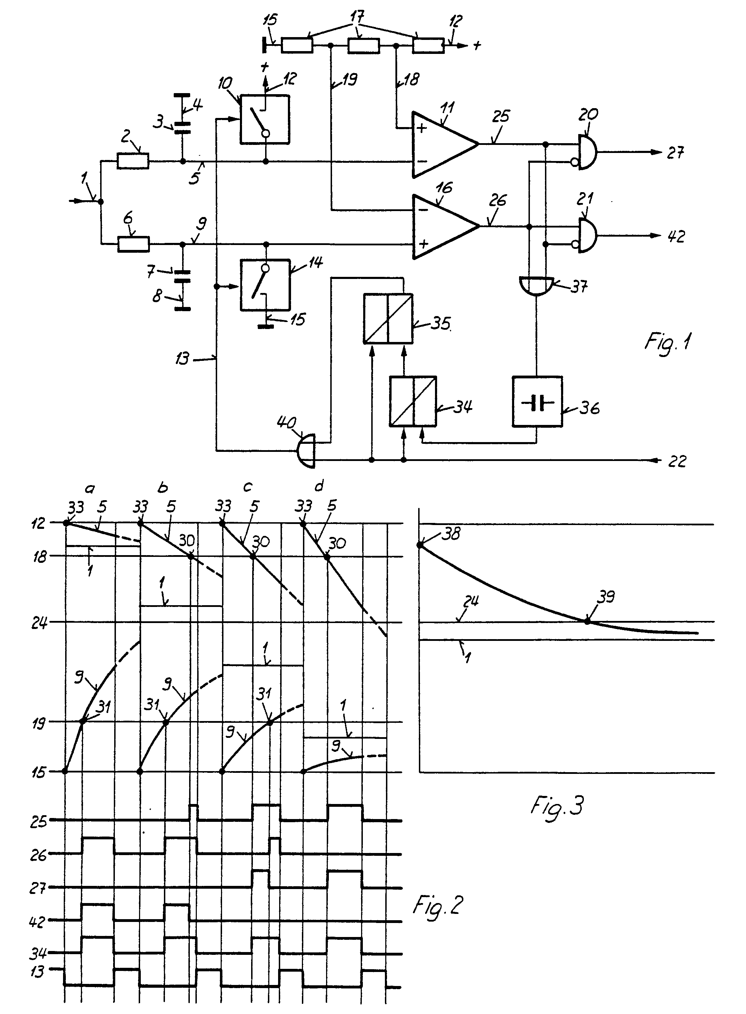

Eine in einem nicht dargestellten Empfänger enthaltene Verarbeitungsstufe für das Rauschen erzeugt an ihrem Ausgang ein Rauschkriterium, dessen Potential bei Abwesenheit eines Signals am Eingang des Empfängers und demgemäss starkem Rauschen am höchsten und beim Eintreffen eines starken Signals und demgemäss verschwindendem Rauschen am niedrigsten ist. Dieses Rauschkriterium wird der Schaltung gemäss Figur 1 am Eingang 1 zugeführt. Bei Eingangssignalen verschiedener Stärke ergeben sich am Eingang 1 Rauschkriterien mit zwischen zwei Extremen liegenden Potentialen.

Das Rauschkriterium 1 ist einerseits über den Widerstand 2 mit dem zweiten Anschluss 5 einer ersten Kapazität 3 und anderseits über einen Widerstand 6 mit dem zweiten Anschluss 9 einer zweiten Kapazität 7 verbunden. Je der erste Anschluss 4 bzw. 8 der beiden Kapazitäten liegt an Masse. Die Widerstände 2 und 6 und die Kapazitäten 3 und 7 werden vorzugsweise je gleich gross gewählt, wodurch die beiden Zeitkonstanten ebenfalls gleich gross sind. Diese Wahl ist jedoch keineswegs Bedingung für die Ausführung des Erfindungsgedankens.

Das Potential 5 am ersten Anschluss der Kapazität 3 liegt auch an einem elektronischen Schalter 10 und an einem ersten Eingang eines ersten Komparators 11. Der Schalter 10 verbindet das in der Folge als Basis-Potential bezeichnete positive Potential 12 mit dem Potential 5, wenn er mit einem Steuersignal 13 über seinen Steuer-Eingang in den leitenden Zustand gesteuert wird. Mit dem gleichen Steuersignal 13 wird über den Schalter 14 das Potential 9 mit dem ebenfalls als Basis-Potential bezeichneten Masse-Potential 15 verbunden. Das Potential 9 liegt auch an einem ersten Eingang eines zweiten Komparators 16.

Je der zweite Eingang der beiden Komparatoren 11 und 16 ist mit einem festen, als Schwellen-Potential wirksamen, mit Hilfe eines Spannungsteilers 17 erzeugten Potentials 18 bzw. 19 verbunden. Beide Potentiale liegen zwischen den Basis-Potentialen 12 und 15; das an den Komparator 11 gelegte Schwellen-Potential 18 ist dabei näher beim positiven Potential 12 und das an den Komparator 16 gelegte Schwellen-Potential 19 näher am Null-Potential 15.

Die Komparatoren sind derart geschaltet, dass der Komparator 11 an seinem Ausgang 25 ein positives Potential abgibt, wenn das Schwellen-Potential 18 stärker positiv ist als das Potential 5, und der Komparator 16 ist derart geschaltet, dass er an seinem Ausgang 26 ein positives Potential abgibt, wenn das Potential 9 stärker positiv ist als das Schwellen-Potential 19.

Die Ausgänge 25 und 26 der beiden Komparatoren 11 und 16 führen je an die zwei Eingänge von zwei UND-Toren 20 und 21, wobei der Ausgang 25 an einen normalen Eingang des Tors 20 und an einen invertierenden Eingang des Tors 21 gelegt ist, während der Ausgang 26 an einen normalen Eingang des Tors 21 und an einen invertierenden Eingang des Tors 20 führt.

Die beschriebene Zufuhr der Potentiale 25 und 26 an normale und invertierende Eingänge der Tore 20 und 21 hat zur Folge, dass am Ausgang 27 des Tors 20 nur dann ein positives Potential erscheint, wenn allein ein Signal 25 vorhanden ist, während am Ausgang 42 des Tors 21 nur dann ein Signal erscheint, wenn allein ein Signal 26 vorhanden ist. Wenn beide oder keines der Signale 25 und 26 vorhanden sind, erscheinen keine Signale an den Ausgängen 27 und 42.

Die beiden Ausgänge 25 und 26 der Komparatoren führen auch auf ein ODER-Tor 37, dessen Ausgang über ein Differenzierglied 36 an den Steuereingang eines monostabilen Multivibrators 34 angeschlossen ist. Der Multivibrator wird dabei mit der Vorderflanke der vom Tor 37 abgegebenen Signale in seine Arbeitslage verbracht. Wenn er in die Ruhelage zurückkehrt, verbringt er einen weitern monostabilen Multivibrator 35 in die Arbeitslage. Solange sich dieser Multivibrator 35 in der Arbeitslage befindet, gibt er an den Eingang eines ODER-Tors 40 ein Signal ab. Am Ausgang dieses Tors 40 erscheint das schon früher erwähnte Steuersignal 13. Dieses Steuersignal wird somit nach Ablauf einer durch den Multivibrator 34 bewirkten Verzögerungszeit immer dann erzeugt, wenn, ausgehend von der Abwesenheit von Ausgangssignalen an den beiden Komparatoren 11 und 16, an den Eingängen eines dieser Komparatoren das Vorzeichen der Potentialdifferenz wechselt. Mit diesem Steuersignal werden in bereits beschriebener Weise die Schalter 10 und 14 betätigt. Mit der Rückkehr des Multivibrators 35 in den Ruhezustand ist das Steuersignal 13 beendet.

Das Steuersignal 13 kann auch durch ein von aussen bei 22 zugeführtes Synchronisiersignal erzeugt werden, wobei dieses Synchronisiersignal die beiden monostabilen Multivibratoren 34 und 35 in ihre Ruhelage zurückstellt, sofern sie sich in der Arbeitslage befinden.

In der Figur 2 ist der zeitliche Verlauf der Potentiale 5 und 9 für vier verschiedene Werte des Potentials 1 des Rauschkriteriums während je einer Messperiode dargestellt. Als waagrechte Linien sind die gleichbleibenden Basis-Potentiale 12 und 15 und die vom Spannungsteiler 17 erzeugten Schwellen-Potentiale 18 und 19 eingezeichnet. Das Grenzwert-Potential 24 ist massgebend, ob ein Signalempfang angenommen werden soll oder nicht, indem bei einem Rückgang des Rauschkriteriums 1 auf einen Wert oberhalb des Grenzwertes 24 kein Empfang und damit keine Belegung des eingestellten Kanals, bei einem Rückgang auf einen Wert unterhalb des Grenzwertes 24 dagegen eine Belegung des betreffenden Kanals angenommen werden soll. Es ist dabei vorteilhaft, das Verhältnis der Differenz zwischen den beiden Potentialen 12 und 18 zur Differenz zwischen den Potentialen 18 und 24 gleich gross zu wählen wie das Verhältnis der Differenz zwischen den beiden Potentialen 15 und 19 zur Differenz zwischen den Potentialen 19 und 24.

Die Darstellung des genannten zeitlichen Verlaufs des Potentials 1 entspricht bei a keinem Empfang, bei b einem sehr schwachen Signal, welches kein Empfangskriterium erzeugen soll, bei c einem schwachen Signal, welches ein Empfangskriterium erzeugen soll und bei d einem starken Signal. Mit dem Steuersignal 13 wird die Zeit in je zwischen zwei aufeinanderfolgenden Steuersignalen liegende Messperioden eingeteilt. Die Länge der Messperioden wird dabei durch die später erklärte Bildung des Steuersignals bestimmt. Während jedes Steuersignals werden die Schalter 10 und 14 leitend geschaltet, wobei die Kapazität 3 aufgeladen wird und das Potential 5 das positive Potential 12 annimmt. Die Kapazität 7 wird demgegenüber entladen, und das Potential 9 nimmt das Null-Potential 15 an.

Sobald am Beginn einer Messperiode die beiden Schalter 10 und 14 in den sperrenden Zustand übergehen, wird die Kapazität 3 entladen und die Kapazität 7 aufgeladen, wobei sich die Änderungsgeschwindigkeit der Potentiale 5 und 9 und der Endzustand des Lade- bzw. des Entladevorgangs nach dem Potential 1 des Rauschkriteriums richten und die Zeitkonstante des Verlaufs durch Kapazität und Widerstand bestimmt ist. Jede Messperiode beginnt mit der Beendigung des Steuersignals. Die betreffenden Zeitpunkte sind in der Figur 2 mit 33 bezeichnet.

In der Figur 2a ist das Potential 1 höher als das Potential 18, so dass der Komparator 11 innerhalb der Messperiode kein Ausgangssignal 25 abgibt. Das Potential 9 überschreitet während der Ladung der Kapazität 7 am Schnittpunkt 31 das Schwellen-Potential 19, wodurch der Komparator 16 an seinem Ausgang 26 ein positives Potential abgibt. Damit erscheint am Ausgang 42 ein Kriterium, welches den Nicht-Empfang eines Signals am Empfängereingang angibt.

Der in Figur 2b dargestellte Verlauf der Potentiale geht von einem Potential 1 des Rauschkriteriums aus, das zwischen dem Schwellen-Potential 18 und dem Grenz-Potential 24 liegt. Im Zeitpunkt 31 erzeugt wiederum der Komparator 16 ein Ausgangssignal, wobei sich die gleichen Vorgänge abspielen, wie sie in bezug auf die Figur 2a beschrieben wurden. Im Zeitpunkt 30, welcher nach dem Zeitpunkt 31 auftritt, unterschreitet das Potential 5 während der Entladung der Kapazität 3 das Potential 18. Dies bleibt jedoch wirkungslos, weil wegen des positiven Potentials 26 das im Zeitpunkt 30 ebenfalls einen positiven Wert an nehmende Potential 25 den Ausgang des Tors 20 nicht beeinflussen kann. Auch in diesem Falle entsteht somit am Ausgang 42 ein Kriterium für den Nicht-Empfang eines Empfänger-Eingangssignals. Sofern sich das Potential 1 näher beim Potential 18 befände, träte das Steuersignal 13 auf, bevor das Potential 5 die Schwelle 18 unterschreiten würde. Die Verhältnisse entsprächen damit denjenigen von Figur 2a.

Bei dem in Figur 2c angenommenen Potential 1 des Rauschkriteriums, welches unterhalb des Schwellen-Potentials 24 liegt, tritt der Schnittpunkt 30 zeitlich vor dem Schnittpunkt 31 ein, womit das Potential 25 vor dem Potential 26 positiv wird. Mit der Änderung des Potentials 25 auf den positiven Wert ändert auch das Potential am Ausgang 27 im gleichen Sinne, was auf ein genügend starkes Signal am Eingang des Empfängers hinweist. Das im Zeitpunkt 31 am Komparator 16 entstehende Ausgangssignal bleibt wirkungslos. In diesem Falle erfolgt die im Zusammenhang mit der Figur 2a beschriebene Bildung des Steuersignals 13 aufgrund des über das Tor 37 zuerst eintreffenden, am Ausgang des Komparators 11 auftretenden Signals 25.

In bezug auf ein (nicht dargestelltes) Eingangspotential 1, welches sehr nahe beim Potential 19 liegt, gelten sinngemäss die gleichen Betrachtungen, wie sie in bezug auf die Figur 2b dargelegt wurden.

Bei einem sehr guten Empfang bleibt, wie in Figur 2d dargestellt, das Potential 1 des Rauschkriteriums unterhalb des Schwellen-Potentials 19, wodurch kein Schnittpunkt 31 entsteht. Es entstehen dabei dieselben Verhältnisse, wie sie in bezug auf Figur 2c beschrieben wurden.

In einem Grenzfall, in welchem das Rauschkriterium 1 gerade das Potential 24 aufweist, treten (in nicht dargestellter Weise) die Schnittpunkte 30 und 31 theoretisch zur gleichen Zeit auf, und es bleibt dem Zufall überlassen, ob ein Empfang festgestellt wird oder nicht. Da der Rauschpegel immer leicht schwankt, entstehen beim Vorliegen eines Grenzwertes des Rauschkriteriums, auf eine Zeitspanne von mehreren Messperioden betrachtet, gleich viele negative und positive Empfangskriterien. Es wäre, um im Grenzbereich eine zuverlässige Empfangsanzeige zu erhalten in bekannter, jedoch nicht dargestellter Weise möglich, die Kriterien 27 und 42 jeweils über eine bestimmte Zeit zu integrieren und ein Empfangskriterium zu bilden, welches sich aus der Mehrheit der während einigen aufeinanderfolgenden Messperioden auftretenden Kriterien ergibt.

Die Zeitpunkte 30 und 31 können durch entsprechende Festlegung der Schwellen-Potentiale 18 und 19 und die Wahl der Zeitkonstanten in gewissen Grenzen beeinflusst werden.

Bei gleichbleibenden Verhältnissen am Empfängereingang wird somit entweder am Ausgang 27 oder am Ausgang 42 eine Impulsreihe mit einem den Messperioden entsprechenden Abständen zwischen den Impulsen erzeugt, wobei sich die Länge der Messperioden nach der Zeit richtet, die jeweils zur Feststellung des Empfangs oder Nichtempfangs eines Signals am Empfängereingang benötigt wird.

Sofern die Schaltungsanordnung in Zusammenarbeit mit einer Einrichtung zur Kanalumschaltung benützt wird, um aus einem Kanalbündel entweder einen freien oder einen besetzten Kanal herauszusuchen, muss jeweils der Beginn einer Messperiode mit der Beendigung der Kanalumschaltung synchronisiert sein. Das Umschalten eines Kanals wird jeweils entsprechend der Art der Kanalsuche - durch einen Impuls 27 oder 42 ausgelöst, wobei - sofern die aufgrund eines solchen Impulses erfolgte Umschaltung beendet ist - auf nicht dargestellte Weise ein Impuls an den Eingang 22 angelegt wird. Durch diesen Impuls wird - unbekümmert um den momentanen Ladezustand der Kondensatoren 3 und 7 - eine neue Messperiode eingeleitet. Vorteilhafterweise werden die Zeitkonstanten der Multivibratoren 34 und 35 derart gewählt, dass sie zusammen etwas länger sind als die Zeit, die für eine Kanalumschaltung benötigt wird. Damit wird verhindert, dass während der Umschaltung störende Impulse an den Ausgängen 27 oder 42 auftreten.

Der Vorteil der Erfindung gegenüber dem Stand der Technik kann am besten anhand der Figur 3 beurteilt werden. Dort ist für ein Rauschkriterium, dessen Potential nur wenig unterhalb des Grenzpotentials 24 liegt und das somit einem schwachen Empfangssignal entspricht, der zeitliche Verlauf des Potentials des Rauschkriteriums dargestellt. Dabei ist angenommen, dass zur Integration des Rauschkriteriums die gleiche Zeitkonstante wirksam ist, wie sie in der Figur 2 vorausgesetzt wurde, und dass im Zeitpunkt 38 das Signal auf den Empfänger trifft bzw. dass der Empfänger im Zeitpunkt 38 auf einen belegten Kanal abgestimmt wird. Wie aus der Figur 3 ersichtlich ist, fällt das Potential des Rauschkriteriums erst beim Punkt 39 unter das Grenzpotential 24. Der zeitliche Abstand der Punkte 38 und 39, d.h. die Zeit zur Feststellung des Empfangs eines Signals beträgt dabei ein Mehrfaches gegenüber den entsprechenden Zeiten bei der Anordnung gemäss der Erfindung. Auch zur Feststellung der Abwesenheit eines Eingangssignals müsste mit einer Einrichtung gemäss dem Stand der Technik nach Einschaltung eines bestimmten Kanals mindestens eine dem Abstand der Punkte 38 und 39 entsprechende Zeit gewartet werden. Wird die Einrichtung in beschriebener Weise für die Suche eines freien oder eines besetzten Kanals benützt, gelingt es, die Kanäle mit einer Geschwindigkeit von ungefähr 50/s abzutasten.

Die Erfindung ist natürlich nicht an das Ausführungsbeispiel gebunden. Sofern nur eine rasche Feststellung schwacher Signale oder nur eine rasche Feststellung eines Nichtempfangs notwendig ist, könnte die Beurteilung der Zeit vom Anfang der Messperiode bis zum Schnittpunkt 30 oder 31 auch durch Vergleich mit einer festen, gleichbleibenden, vorzugsweise durch Abzählen von Schwingungen gewonnenen Bezugszeit erfolgen, wodurch jeweils eine der Kapazitäten und einer der Komparatoren entbehrt werden könnten. Dabei wären, entsprechend der erwähnten Aufgabenstellung, die Bauteile gemäss der obern oder untern Hälfte der Figur 1 wegzulassen. In einer Anordnung dieser Art könnte der Takt auch durch einen Impulserzeuger mit festem Takt erzeugt werden.

Die einerseits aus der Kapazität 3 mit dem zugehörigen Widerstand 2 und die anderseits aus der Kapazität 8 mit dem zugehörigen Widerstand 6 gebildeten Zeitkonstanten müssen nicht gleich gross gewählt werden; es ist für jede Wahl solcher Zeitkonstanten eine derartige Festsetzung der Schwellenwerte 18 und 19 möglich, dass die verlangten Bedingungen erfüllt werden.

Da die Stärke des Rauschens von der Speisespannung, von der Temperatur und von der Alterung der Bauelemente abhängt, könnte die Genauigkeit der Empfangsanzeige verbessert werden, wenn für das Potential 12 anstelle eines festen Wertes ein zum Rauschpegel bei Abwesenheit eines Eingangssignals proportionaler Wert gewählt würde.

Die Auswertung der zeitlichen Differenz des Auftretens der Schnittpunkte 30 und 31 kann natürlich auch auf andere als im Beispiel beschriebene Weise bewerkstelligt werden; insbesondere kann die ganze an die Komparatoren und den Synchronisiereingang angeschlossene Schaltung in wesentlich vom Beispiel abweichender Weise aufgebaut sein und wird vorzugsweise als integrierte Schaltung ausgeführt.

Das feste Potential, an welchem die Kapazitäten angeschlossen sind, muss nicht für beide Kapazitäten das gleiche und auch nicht Masse sein. Wird ein anderes Potential gewählt, findet anstelle einer im Ausführungsbeispiel beschriebenen Ladung eine Entladung statt und umgekehrt; grundsätzlich ändert dabei nichts.

## Patentansprüche

1. Schaltungsanordnung in einem Empfänger für drahtlose Signale zur Erzeugung eines Empfangskriteriums, d.h. zur Feststellung des Empfangs bzw. Nichtempfangs eines Signals, insbesondere für Empfänger mit abwechslungsweisem Empfang auf mehreren Kanälen und einer Einrichtung zur Suche eines freien bzw. eines belegten Kanals, mit Schaltungsmitteln zur Erzeugung eines der Stärke des Rauschens am Empfängerausgang proportionalen, die Form eines Gleichspannungspotentials aufweisenden Rauschkriteriums (1) und zur Unterscheidung des Empfangs gegenüber dem Nichtempfang eines drahtlosen Signals anhand des Vorzeichens der Differenz zwischen dem Potential des Rauschkriteriums (1) und einem Grenzwert-Potential (24), mit ersten Schaltungsmitteln (35) zur Abgrenzung von Messperioden, mit zweiten Schaltungsmitteln (10; 14), welche an einer Kapazität (3; 7), von der ein erster Anschluss (4; 8) an einem beliebigen festen Potential liegt, einen zweiten Anschluss (5; 9) vor Beginn einer Messperiode mit einem die Grössenordnung eines der möglichen Extremwerte des Potentials des Rauschkriteriums (1) aufweisenden Basis-Potential (12; 15) und während der Messperiode über einen Widerstand (2, 6) mit dem Potential des Rauschkriteriums (1) verbinden und mit einen Ausgang (25; 26) aufweisenden dritten Schaltungsmitteln (11; 16), welche das am genannten zweiten Anschluss (5; 9) liegende Potential mit einem Schwellen-Potential (18; 19) vergleichen, wobei das an ihrem Ausgang auftretende Potential allein vom Vorzeichen der Differenz der zu vergleichenden Potentiale abhängt, dadurch gekennzeichnet, dass das Schwellen-Potential (18; 19) zwischen das Basis-Potential (12; 15) und das Grenzwert-Potential (24) gelegt ist, und dass vierte Schaltungsmittel (20, 21) vorhanden sind, welche den Empfang bzw. Nichtempfang eines Signals aufgrund des Zeitpunktes (30, 31), in welchem innerhalb der betreffenden Messperiode ein Wechsel des Vorzeichens des genannten Ausgangssignals (25; 26) auftritt, bestimmen.

2. Schaltungsanordnung nach Patentanspruch 1, gekennzeichnet durch Schaltungsmittel zur Erzeugung je einer vom Beginn jeder Messperiode an laufenden Bezugszeit und durch eine Ausbildung der vierten Schaltungsmittel (20, 21), gemäss welcher diese das Empfangskriterium von der zeitlichen Reihenfolge der Zeitpunkte des Ablaufs der Bezugszeit und des Auftretens des Vorzeichenwechsels abhängen lassen.

3. Schaltungsanordnung nach Patentanspruch 2, dadurch gekennzeichnet, dass die Kapazität (3, 8), die zweiten (10, 14) und die dritten (11, 16) Schaltungsmittel doppelt angeordnet sind, wobei Basis-Potential (12, 15) und Schwellen-Potential (18, 19) bei jeder dieser beiden Gruppen einem der beiden Extremwerte zugeordnet und somit verschieden gewählt sind, und dass von den beiden je zwischen dem Beginn der Messperiode (33) und dem Zeitpunkt des Vorzeichenwechsels (30, 31) entstehenden Zeitspannen die eine als Bezugszeit für die andere verwendet ist.

4. Schaltungsanordnung nach Patentspruch 3, dadurch gekennzeichnet, dass die je aus einer der genannten Kapazitäten (3; 7) und dem zugehörigen Widerstand (2; 6) sich ergebenden Zeitkonstanten gleich gross gewählt sind und dass je das Verhältnis aus der Differenz zwischen dem Grenzwert-Potential (24) und einem der Basis-Potentiale (12, 15) und der Differenz zwischen dem diesem Basis-Potential nahestehenden Schwellen-Potential (18, 19) und dem Grenzwert-Potential (24) bei beiden Gruppen von Schaltungsmitteln gleich gross ist.

5. Schaltungsanordnung nach Patentanspruch 2, gekennzeichnet durch fünfte, von beiden dritten Schaltungsmitteln (11, 16) beeinflusste, Verzögerungsmittel enthaltende Schaltungsmittel (37, 36, 34, 35), welche, nachdem sie mindestens einen der genannten Wechsel des Vorzeichens festgestellt haben, nach Ablauf einer die Dauer einer Messperiode unterschreitenden Verzögerungszeit die ersten Schaltungsmittel (35) zur Einleitung einer neuen Messperiode veranlassen.

## Claims

1. Circuit arrangement in a receiver for wireless signals for generating a receive criterion, i.e. for detecting the reception or non-reception of a signal, particularly for receivers having alternating reception on several channels and facilities for seeking a free or an occupied channel, having circuit means for generating a noise criterion (1) proportional to the strength of the noise at the receiver output and taking the form of a d.c. voltage potential and for differentiating between the reception and the non-reception of a wireless signal with the aid of the polarity of the difference between the potential of the noise criterion (1) and a limit potential (24), having first circuit means (35) for delimiting measurement periods, having second circuit means (10; 14) which, on a capacitance (3; 7), to a first terminal (4; 8) of which any desired fixed potential is applied, connect a second terminal (5; 9) before the beginning of a measurement period to a base potential (12; 15) having the magnitude of one of the possible extreme values of the potential of the noise criterion (1) and during the measurement period via a resistance (2, 6) to the potential of the noise criterion (1), and having third circuit means (11; 16), including an output (25; 26), which compare the potential applied to the said second terminal (5; 9) with a threshold potential (18; 19), the potential appearing at their output depending solely upon the polarity of the difference between the potentials to be compared, characterized in that the threshold potential (18; 19) is between the base potential (12; 15) and the limit potential (24), and that there are fourth circuit means (20, 21) which determine the reception or non-reception of a signal based upon the moment (30, 31) at which a change of the polarity of the said output signal (25; 26) occurs within the respective measurement period.

2. Circuit arrangement according to patent claim 1, characterized by circuit means for generating a respective reference time running from the beginning of each measurement period and by a formation of the fourth circuit means (20, 21) according to which the latter cause the receive criterion to depend upon the chronological order of the moments of the lapse of the reference time and the occurrence of the change of polarity.

3. Circuit arrangement according to patent claim 2, characterized in that the capacitance (3, 8), the second (10, 14) and the third (11, 16) circuit means are double, the base potential (12, 15) and the threshold potential (18, 19) in each of these two groups being associated with one of the two extreme values and thus differently selected, and that of the two periods of time respectively occurring between the beginning of the measurement period (33) and the moment of the change of polarity (30, 31), one is used as a reference time for the other.

4. Circuit arrangement according to patent claim 3, characterized in that the time constants respectively resulting from one of the said capacitances (3; 7) and the associated resistance (2; 6) are selected equally great, and that the respective ratio of the difference between the limit potential (24) and one of the base potentials (12, 15) to the difference between the threshold potential (18, 19) close to this base potential and the limit potential (24) is equally great in both groups of circuit means.

5. Circuit arrangement according to patent claim 2, characterized by fifth circuit means (37, 36, 34, 35) influenced by both third circuit means (11, 16) and containing delay means, which fifth circuit means, after they have detected at least one of the said changes of polarity, cause the first circuit means (35) to initiate a new measurement period after elapsing of a delay time lasting less than the duration of a measurement period.

**Revendications**

1. Circuit appartenant à un récepteur de signaux sans fil, servant à la production d'un critère de réception, c'est-à-dire à la détermination de la réception ou de la non-réception d'un signal, destiné plus particulièrement à un récepteur qui reçoit séquentiellement sur plusieurs canaux et est pourvu d'un dispositif de recherche d'un canal libre ou occupé, circuit comprenant des moyens capables de produire un critère de bruit (1) proportionnel au bruit à la sortie du récepteur et présentant la forme d'un potentiel constant, et de discriminer la réception d'un signal sans fil de l'absence de réception sur la base du signe de la différence entre le potentiel du critère de bruit (1) et un potentiel limite (24), comprenant en outre une première circuiterie (35) de détermination de périodes de mesure, une deuxième circuiterie (10; 14) qui est reliée à une capacité (3; 7) dont une première borne (4; 8) se trouve à un potentiel fixe et arbitraire, et une seconde borne (5; 9) se trouve avant le début d'une période de mesure à un potentiel de base (12; 15) dont l'ordre de grandeur correspond à l'une des valeurs extrêmes possibles pour le potentiel du critère de bruit (1) et pendant la période de mesure, par l'intermédiaire d'une résistance (2, 6) au potentiel du critère de bruit (1), et une troisième circuiterie (11; 16) qui présente une sortie (25; 26) et compare le potentiel apparaissant à ladite seconde borne (5; 9) avec un potentiel de seuil (18; 19), et dont le potentiel apparaissant à sa sortie ne dépend que du signe de la différence des potentiels comparés, caractérisé en ce que le potentiel de seuil (18; 19) est situé entre les potentiels de base (12; 15) et limite (24) et en ce qu'une quatrième circuiterie (20, 21) est prévue, qui discrimine la réception ou l'absence de réception d'un signal sur la base du moment (30, 31) auquel, au cours de la période de mesure, il se produit un changement du signe du signal de sortie (25; 26).

2. Circuit selon la revendication 1, caractérisé par des moyens produisant des temps de référence qui s'écoulent chacun depuis le début d'une période de mesure, et par une conformation de la quatrième circuiterie (20, 21), assurant que celle-ci fait dépendre le critère de réception de la succession dans le temps des fins des temps de référence et des renversements de signe des différences.

3. Circuit selon la revendication 2, caractérisé en ce que la capacité (3, 8) et les deuxième (10, 14) et troisième (11, 16) circuiteries sont disposées à double, une des valeurs extrêmes du potentiel de base (12, 15) et du potentiel de seuil (18, 19) étant affectée à chacun de ces deux groupes d'éléments, de manière que ces valeurs soient choisies différemment, l'un des deux temps qui s'écoulent entre le début de la période de mesure (33) et le moment des renversements de signe (30, 31) servant de temps de référence pour l'autre.

4. Circuit selon la revendication 3, caractérisé en ce que les constantes de temps déterminées chacune par une des capacités (3; 7) et la résistance correspondante (2; 6) sont choisies de même grandeur, et en ce que pour chacun des deux groupes d'éléments, le rapport de la différence entre le potentiel limite (24) et l'un des potentiels de base (12, 15) à la différence entre le potentiel de seuil (18, 19) le plus proche du potentiel de base correspondant et le potentiel limite (24) est de même grandeur.

5. Circuit selon la revendication 2, caractérisé en ce qu'il comporte une cinquième circuiterie (37, 36, 34, 35) influencée par les deux troisièmes circuiteries (11, 16) contenant des moyens de retard et provoquant l'enclenchement d'une nouvelle période de mesure par la première circuiterie (35) après avoir constaté au moins un desdits changements de signe après l'écoulement d'un temps de retard inférieur à la durée d'une période de mesure.

Fig. 1

Fig. 2

Fig. 3